# EUROPEAN PATENT APPLICATION

(11) **EP 2 200 095 A2**
(43) Date of publication of application: **23.06.2010**
(21) Application number: 09172161.3
(22) Date of filing: 05.10.2009
(51) Int. Cl.: H01L 31/058

(54) **Photovoltaic-thermal hybrid apparatus**

(30) Priority: 22.12.2008 KR 20080131668
(71) Applicant: Samsung Electronics Co., Ltd., Suwon-si, Gyeonggi-Do (KR)
(72) Inventor: Oh, Jae Hyuk, Gyeonggi-do (KR); Wu, Seong Je, Gyeonggi-do (KR); Han, Seong Joo, Gyeonggi-do (KR); Choi, See Young, Gyeonggi-do (KR)
(74) Representative: Grünecker, Kinkeldey, Stockmair & Schwanhäusser Anwaltssozietät

(57) **Abstract**

Disclosed herein is a photovoltaic-thermal hybrid apparatus. The photovoltaic-thermal hybrid apparatus includes at least one condenser to change a direction of some incident solar energy therein in a radial direction and emit some incident solar energy outside, a solar cell disposed at least one side of the condenser, and a frame to surround the condenser, the frame having a cooling channel to cool the solar cell disposed at at least one side therein.

## Description

### BACKGROUND

### 1. Field

The present invention relates to an apparatus using solar energy, and, more particularly, to a photovoltaic-thermal hybrid apparatus that is capable of generating electricity using solar energy and, at the same time, recovering solar heat that has not been converted into electricity.

### 2. Description of the Related Art

There have been developed a photovoltaic technology using a light of the sun using a module including solar cells, a solar thermal technology using a thermal property of the sun through a solar collector, and a hybrid technology using both the photo and thermal properties of the sun.

The photovoltaic technology using the light of the sun is a method using a principle in which, when solar light of a wavelength range having energy greater than a threshold energy of a semiconductor is incident upon a solar cell formed by the p-n junction of semiconductors, current flows in a load connected externally to the solar cell by a photoelectric effect. As needed, solar cells may be connected in series and/or in parallel.

The solar thermal technology using the thermal property of the sun is a method of receiving incident solar energy using a solar collector and recovering heat through a heat medium. The solar thermal technology has the most widespread use at the current time.

The solar energy hybrid technology, which is an improvement of the above-mentioned two technologies, is a technology that is capable of simultaneously obtaining two kinds of energy from the sun using a flat photovoltaic-thermal hybrid panel. This solar energy hybrid technology is used to produce electricity and heat.

However, the conventional solar energy hybrid technology is nothing but the combination of an apparatus using a light component of the solar energy and an apparatus using a heat component of the solar energy, with the result that it is not possible to entirely and effectively use the solar energy, and therefore, energy efficiency lowers.

Also, the conventional heat collector used to collect solar heat has low absorption of energy and large area of loss. For a natural convection type heat collector, the absorbed energy is emitted, which leads to great heat loss.

Also, the solar cells used in the conventional solar energy hybrid apparatus have a large size, with the result that the manufacturing costs of the solar cells increase. Furthermore, the volume of the apparatus is great, and, in particular, the thickness of the apparatus is great, with the result that installation environment and condition are severely restricted.

### SUMMARY

Therefore, it is an aspect of the present invention to provide a photovoltaic-thermal hybrid apparatus that is capable of improving power generation efficiency with a reduced installation area.

It is another aspect of the present invention to provide a photovoltaic-thermal hybrid apparatus constructed in a structure to achieve photovoltaic power generation and solar heat recovery with a minimized thickness.

It is a further aspect of the present invention to provide a photovoltaic-thermal hybrid apparatus constructed in a structure to exhibit high efficiency and, at the same time, reduce the manufacturing costs.

Additional aspects and/or advantages will be set forth in part in the description which follows and, in part, will be apparent from the description, or may be learned by practice of the invention.

Accordingly, it is an aspect of the present invention to provide a photovoltaic-thermal hybrid apparatus including: a condenser to receive solar energy and change a direction of some of the received solar energy therein to a radial direction of the condenser and emit some of the incident solar energy to an outside; a solar cell disposed at a first side of the condenser to convert some of the direction-changed solar energy to electricity; and a frame to surround the condenser, the frame having a first cooling channel to cool the solar cell.

The photovoltaic-thermal hybrid apparatus may further include a thermal diffusion layer disposed between the solar cell and the cooling channel, to transmit energy that has not been converted into electricity by the solar cell to the cooling channel.

The photovoltaic-thermal hybrid apparatus may further include a heat insulator to fix the solar cell and the cooling channel and to thermally insulate the solar cell and the cooling channel from the outside.

The at least one condenser may include a plurality of stacked condensers, and the condensers may transmit the solar energy to the neighboring condensers. The photovoltaic-thermal hybrid apparatus may further include a reflector disposed at another side of the condenser to reflect the solar energy to the solar cell. The solar cell may include solar cells disposed at some sides of the condenser, and the reflector may include reflectors disposed at the remaining sides of the condenser.

The reflector may be inclined toward the solar cell. The photovoltaic-thermal hybrid apparatus may further include a cooling channel disposed at a rear of the reflector to cool the reflector and recover solar heat. The photovoltaic-thermal hybrid apparatus may further include a thermal diffusion layer disposed between the reflector and the cooling channel to transmit energy from the reflector to the cooling channel.

The photovoltaic-thermal hybrid apparatus may further include a heat insulator disposed in the frame to surround the thermal diffusion layer and the cooling channel and prevent discharge of heat.

The photovoltaic-thermal hybrid apparatus may further include a heat exchange fin disposed at a rear of the solar cell to enlarge a heat exchange area.

The cooling channel may include a micro channel configured in a micro structure to form a fluid flow channel.

The cooling channel may include an introduction port through which a fluid is introduced, a plurality of channel parts diverging from the introduction port to surround the solar cell, and a discharge port, joining the channel parts, through which the fluid is discharged.

The foregoing and/or other aspects of the present invention may be achieved by providing a photovoltaic-thermal hybrid apparatus including: a condenser to receive solar energy and change a direction of some of the received solar energy therein to a radial direction of the condenser and guide the direction-changed solar energy to a side of the condenser; a solar cell disposed at a first side of the condenser; a reflector disposed at a second side of the condenser, such that the reflector is opposite to the solar cell, to reflect some of the direction-changed solar energy to the solar cell; a first cooling channel disposed at a rear of the solar cell to cool the solar cell and recover solar heat; and a frame to surround the condenser, the solar cell, the reflector, and the first cooling channel.

The photovoltaic-thermal hybrid apparatus may further include a second cooling channel disposed in the frame to cool the reflector and recover the solar energy. The photovoltaic-thermal hybrid apparatus may further include a heat insulator filling the frame. The photovoltaic-thermal hybrid apparatus may further include a third cooling channel disposed at a bottom of the condenser recover heat from the condenser.

### BRIEF DESCRIPTION OF THE DRAWINGS

These and/or other aspects and advantages of the invention will become apparent and more readily appreciated from the following description of the embodiments, taken in conjunction with the accompanying drawings of which:
FIG. 1 is a sectional view schematically illustrating a photovoltaic-thermal hybrid apparatus according to an embodiment of the present invention;
FIG. 2 is a sectional view taken along line A-A' of FIG. 1;
FIG. 3 is a view illustrating the operation of the photovoltaic-thermal hybrid apparatus of FIG. 1;
FIG. 4 is a sectional view schematically illustrating a photovoltaic-thermal hybrid apparatus according to another embodiment of the present invention;
FIG. 5 is a sectional view taken along line B-B' of FIG. 4;
FIG. 6 is a view illustrating the operation of the photovoltaic-thermal hybrid apparatus of FIG. 4;
FIGS. 7 and 8 are sectional views schematically illustrating a photovoltaic-thermal hybrid apparatus according to still another embodiment of the present invention;
FIG. 9 is a sectional view schematically illustrating a photovoltaic-thermal hybrid apparatus according to a further embodiment of the present invention; and
FIGS. 10A to 10E are sectional views illustrating modifications of a cooling channel in the photovoltaic-thermal hybrid apparatus according to the embodiment of the present invention.

### DETAILED DESCRIPTION OF EMBODIMENTS

Reference will now be made in detail to the embodiments of the present invention, examples of which are illustrated in the accompanying drawings, wherein like reference numerals refer to the like elements throughout. The embodiments are described below to explain the present invention by referring to the figures.

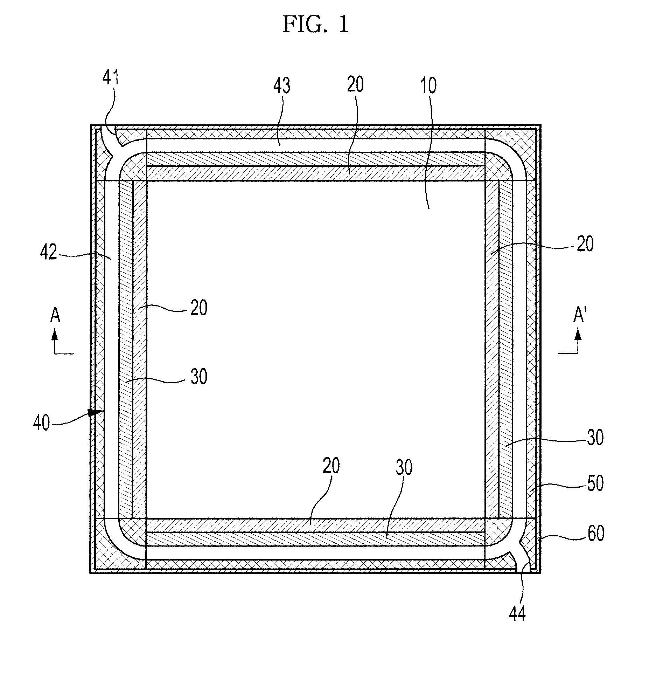

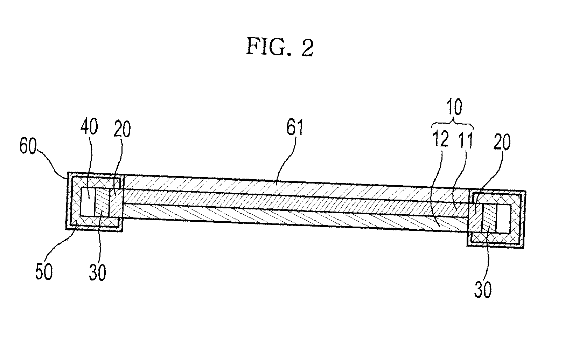

FIG. 1 is a sectional view schematically illustrating a photovoltaic-thermal hybrid apparatus according to an embodiment of the present invention, and FIG. 2 is a sectional view taken along line A-A' of FIG. 1.

As shown in FIGS. 1 and 2, the photovoltaic-thermal hybrid apparatus may include a condenser 10 to absorb incident solar energy and radially emit the solar energy therein, solar cells 20 installed at the edges of the condenser 10, thermal diffusion layers 30 to absorb energy that has not been converted into electricity by the solar cells 20, a cooling channel 40 disposed at the rears of the thermal diffusion layers 30 to cool the solar cells 20 and recover solar heat, a heat insulator 50 to prevent heat in the thermal diffusion layers 30 and the cooling channel 40 from discharging outside, and a frame 60 to surround the condenser 10, the frame 60 having the cooling channel 40 therein.

Above the condenser 10 may be provided a transmission layer 61 made of plate glass or a transparent material exhibiting high transmissivity of solar energy.

In this embodiment, the condenser 10 is implemented by a plurality of stacked panels although the condenser 10 may be implemented by a single flat panel.

The condenser 10 is constructed in a structure to absorb solar energy, to change the direction of some of the solar energy such that some of the solar energy radially moves in the condenser 10, and to transmit the remaining solar energy.

An example of the condenser 10 is disclosed in U.S. Patent Application Publication No. 2005-290625, the disclosure of which is substituted for the detailed structure of the condenser 10.

The condenser 10 may include a first condenser 11 disposed adjacent to the transmission layer 61 in parallel to the transmission layer 61 to absorb solar energy incident through the transmission layer 61, to change the direction of some of the solar energy such that some of the solar energy radially moves therein, and to transmit the remaining solar energy, and a second condenser 12 disposed at the bottom of the first condenser 11 to absorb the solar energy transmitted through the first condenser 11, to change the direction of some of the solar energy such that some of the solar energy radially moves therein, and to transmit the remaining solar energy.

Although not shown, a third condenser may be disposed at the bottom of the second condenser in the same manner. Also, a fourth condenser may be disposed at the bottom of the third condenser in the same manner.

The condenser may be implemented by a plurality of stacked condensers, the number of which is not limited to 2 to 4.

In this embodiment, the condenser 10 is formed in the shape of a rectangular panel although the condenser 10 may be formed in the shape of a polygon or other different shapes.

In this embodiment, the transmission layer 61 and the first condenser 11 may be in contact with each other or spaced apart from each other by several micrometers to dozens of centimeters.

Each solar cell 20, having a size corresponding to each side of the condenser 10, is fixed to each side of the condenser 10. Since the condenser 10 is formed in the shape of a thin plate, each solar cell 20 corresponding to each side of the condenser 10 may be formed in the shape of a long bar.

Each thermal diffusion layer 30 is made of a material exhibiting high heat conductivity. Each thermal diffusion layer 30 is mounted to the rear of the corresponding solar cell 20 to absorb energy that has not been converted into electricity by the corresponding solar cell 20 and transmit the absorbed energy to the cooling channel 40.

The cooling channel 40 is disposed at the rears of the thermal diffusion layers 30 such that the cooling channel 40 surrounds the thermal diffusion layers 30.

The solar energy transmitted from the solar cells 20 through the thermal diffusion layers 30 is heat-exchanged with a cooling fluid flowing along the cooling channel 40. As a result, the cooling fluid recovers the solar heat that has not been converted into electric energy.

The cooling channel 40 may include an introduction port 41 through which a fluid is introduced, first and second channel parts 42 and 43 diverging from the introduction port 41 to surround the solar cells 20, and a discharge port 44 through which the fluid is discharged.

In this embodiment, the first and second channel parts 42 and 43 are formed in the sectional shape of a rectangle although the first and second channel parts 42 and 43 may be formed in various sectional shapes, such as a triangle, a polygon, a circle, and an ellipse.

The introduction port 41 and the discharge port 44 of the cooling channel 40 may be selectively interchanged.

Although common tap water may be used as the cooling fluid flowing along the cooling channel 40, ionic water or other different fluids may be used to prevent pollution and improve durability. Also, gas, such as air, may be used. The cooling channel may be implemented by a heat pipe.

The frame 60 may be filled with the heat insulator 50, which fixes the thermal diffusion layers 30 and the cooling channel 40. Also, the heat insulator 50 surrounds the thermal diffusion layers 30 and the cooling channel 40 to prevent heat in the thermal diffusion layers 30 and the cooling channel A from discharging outside, thereby improving efficiency.

The frame 60 is disposed outside the heat insulator 50 to integrate the photovoltaic-thermal hybrid apparatus into a single unit.

Hereinafter, the operation of the photovoltaic-thermal hybrid apparatus according to this embodiment will be described.

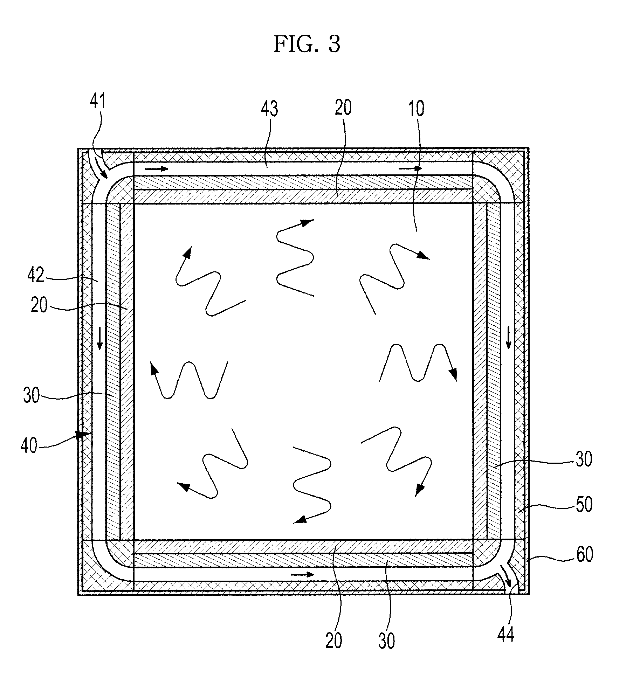

FIG. 3 is a view illustrating the operation of the photovoltaic-thermal hybrid apparatus of FIG. 1.

In the photovoltaic-thermal hybrid apparatus, as shown in FIG. 3, solar energy incident upon the transmission layer 61 reaches the first condenser 11. Some of the solar energy radially moves in the first condenser 11. The remaining solar energy passes through the first condenser 11 and is incident upon the second condenser 12. Some of the solar energy incident upon the second condenser 12 radially moves in the second condenser 12. That is, the solar energy incident upon the first and second condensers 11 and 12 radially moves toward the edges of the first and second condensers 11 and 12 by a material constituting the first and second condensers 11 and 12. The solar energy guided to the edges of the condenser 10 is converted into electricity by the solar cells 20.

Solar energy incident upon the transmission layer 61 having a large area is accumulatively transmitted to the solar cells 20 disposed at the respective sides of the thin condenser 10, and therefore, condensing efficiency is improved. Also, the heat that has not been converted into electricity by the solar cells 20 is transmitted to the cooling channel 40 through the thermal diffusion layers 30, exhibiting high heat conductivity, formed at the rears of the respective solar cells 20. The heat is recovered by a cooling fluid flowing in the cooling channel.

The photovoltaic-thermal hybrid apparatus according to this embodiment is constructed in a thin module type structure to achieve photovoltaic power generation and heat recovery by preparing flat panel type condensers 10, and disposing solar cells 20 and a cooling channel 40 at the edges of each condenser 10.

Not only solar cell power generation but also solar heat recovery is possible, thereby achieving high overall efficiency. Consequently, much energy acquisition at the same installation area is possible. Also, since the photovoltaic-thermal hybrid apparatus is manufactured in a very thin module type structure, it is possible to minimize the restrictions of an installation place and installation condition which a common large-volume concentration type photovoltaic system suffers.

Hereinafter, a photovoltaic-thermal hybrid apparatus according to another embodiment will be described.

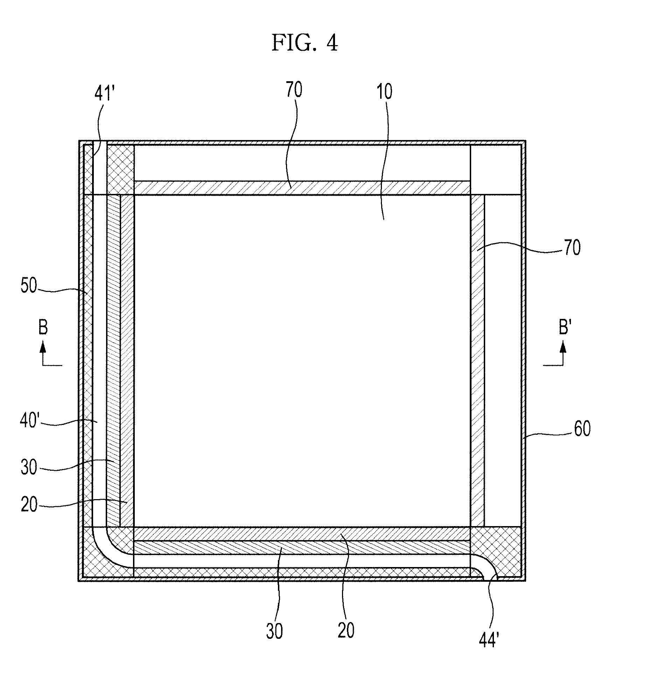

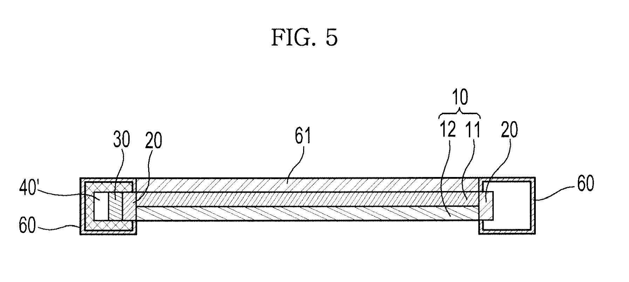

FIG. 4 is a sectional view schematically illustrating a photovoltaic-thermal hybrid apparatus according to another embodiment of the present invention, and FIG. 5 is a sectional view taken along line B-B' of FIG. 4.

The photovoltaic-thermal hybrid apparatus according to this embodiment is substantially identical in construction of photovoltaic-thermal modules and assembly using the photovoltaic-thermal modules to that according to the previous embodiment except that some solar cells mounted at the edges of a condenser are replaced by reflectors, and thermal diffusion layers and a channel are omitted from the rears of the reflectors.

The same elements of this embodiment as the previous embodiment are denoted by the same reference numerals, and a description thereof will not be given.

As shown in FIGS. 4 and 5, the photovoltaic-thermal hybrid apparatus may include reflectors 70 installed at the other edges of the condenser 10 to reflect incident solar energy to the solar cells 20 and a cooling channel 40' disposed at the rears of the thermal diffusion layers 30 to cool the solar cells 20 and recover solar heat.

In this embodiment, the condenser 10 is formed of a rectangular panel, the solar cells 20 are disposed at the two neighboring edges of the condenser 10, and the reflectors 70 are disposed at the remaining neighboring edges of the condenser 10 opposite to the solar cells 20. Although the condenser 10 is formed in the shape of an arbitrary polygon, the solar cells and the reflectors may be arranged in various structures to move solar energy incident upon the reflectors toward the solar cells.

Each thermal diffusion layer 30, having a size corresponding to each solar cell 20, is only mounted to the rear of the corresponding solar cell 20. The cooling channel 40' is installed in contact with the thermal diffusion layers 30. An introduction port 41' is formed at one end of the cooling channel 40', and a discharge port 44' is formed at the other end of the cooling channel 40', such that a fluid flows along the cooling channel 40' in one direction.

Hereinafter, the operation of the photovoltaic-thermal hybrid apparatus according to this embodiment will be described.

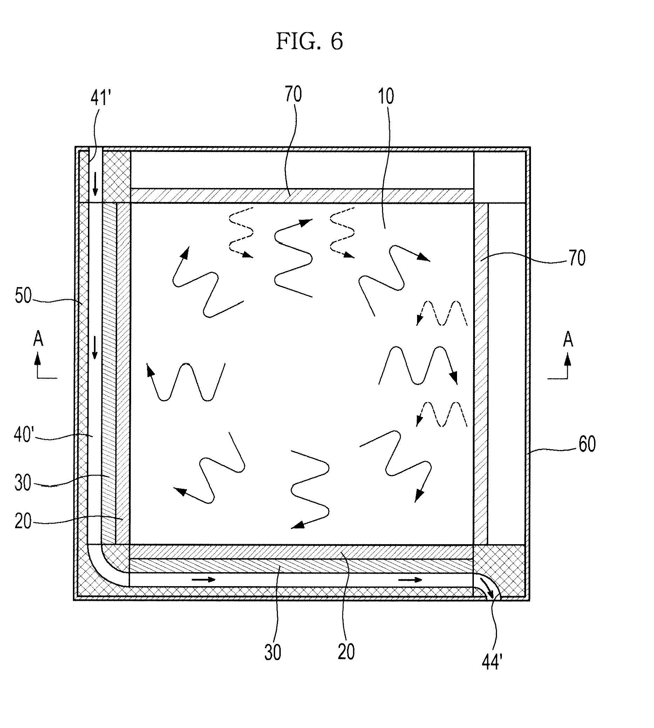

FIG. 6 is a view illustrating the operation of the photovoltaic-thermal hybrid apparatus of FIG. 4.

Solar energy incident upon the transmission layer 61 reaches the first condenser 11. Some of the solar energy radially moves in the first condenser 11. The remaining solar energy passes through the first condenser 11 and is incident upon the second condenser 12. Some of the solar energy incident upon the second condenser 12 radially moves in the second condenser 12. That is, the solar energy incident upon the first and second condensers 11 and 12 radially moves toward the reflectors 70 disposed at the two neighboring edges of the first and second condensers 11 and 12 by a material constituting the first and second condensers 11 and 12. The solar energy, reaching the reflectors 70, is reflected to the solar cells 20 disposed at the remaining neighboring edges of the first and second condensers 11 and 12.

As a result, the solar energy incident upon the solar cells 20 is converted into electric energy. The remaining solar heat is recovered by the fluid flowing along the cooling channel 40' through the thermal diffusion layers 30.

Also, no coolant pipe is installed at the rears of the reflectors 70 since it is not necessary to recover heat, and therefore, the installation of the heat insulation layer may also be omitted.

Therefore, it is possible to increase a concentration ratio while reducing the installation area of the high-priced solar cells, thereby maintaining efficiency while reducing the costs. Also, it is not necessary to install the thermal diffusion layers, the cooling channel, and the heat insulation layer at the sides where the reflectors are installed, thereby improving convenience in manufacture and installation and reducing the manufacturing costs.

Hereinafter, a photovoltaic-thermal hybrid apparatus according to another embodiment will be described.

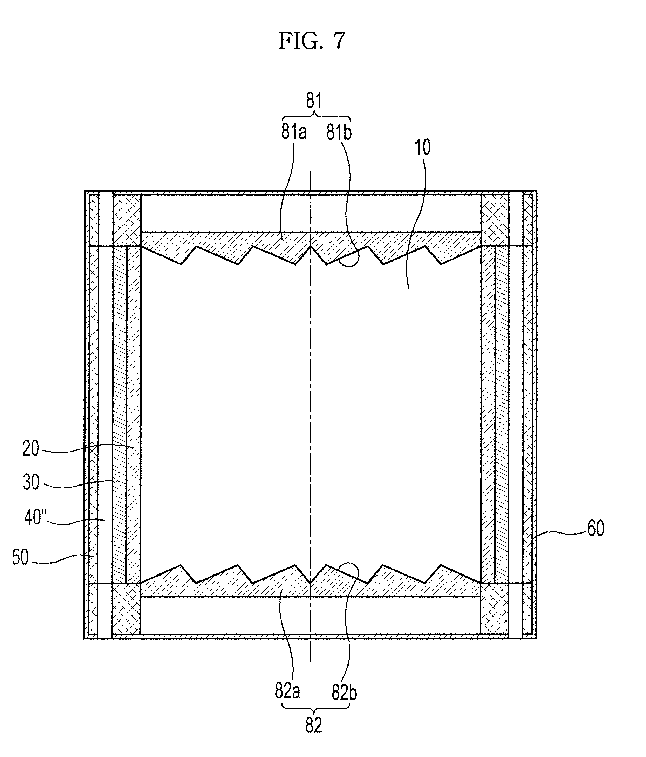

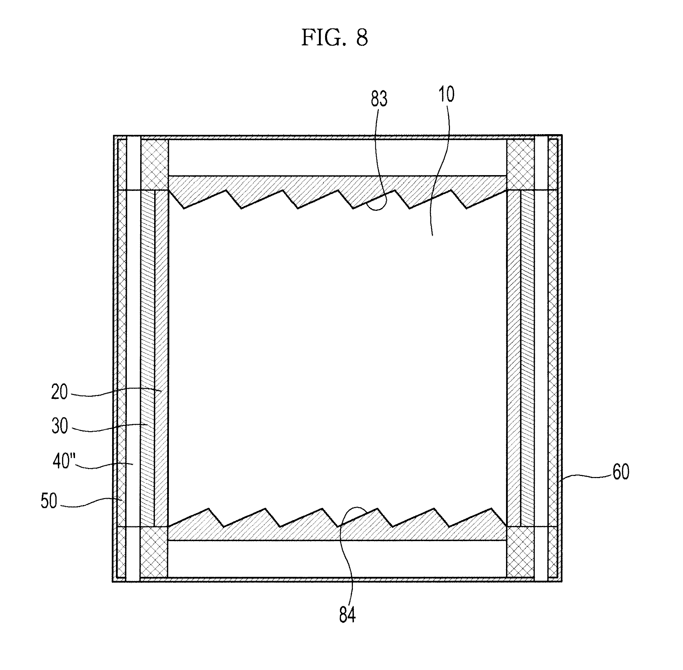

FIGS. 7 and 8 are sectional views schematically illustrating a photovoltaic-thermal hybrid apparatus according to another embodiment of the present invention.

The photovoltaic-thermal hybrid apparatus according to this embodiment is substantially identical in construction to that according to the previous embodiment except that there is a slight difference between these embodiments with respect to the installation positions of solar cells, the installation positions of thermal diffusion layers and a cooling channel, and the shape of reflectors.

The same elements of this embodiment as the previous embodiment are denoted by the same reference numerals, and a description thereof will not be given.

As shown in FIGS. 7 and 8, corresponding pairs of reflectors 81 and 82; 83 and 84 are disposed at two opposite edges of the condenser 10, and a pair of solar cells 20 are disposed at the other two opposite edges of the condenser 10.

In the embodiment of FIG. 7, the reflectors 81 and 82 may be formed in the sectional shape of sawteeth symmetrical about the center line, or, in the embodiment of FIG. 8, the reflectors 83 and 84 may be formed in the sectional shape of sawteeth arranged in one direction.

In this embodiment, the reflectors are formed in the sectional shape of the sawteeth although the reflectors may be formed in various shapes to transmit solar energy toward the solar cells opposite thereto.

In the same manner as the previous embodiment, thermal diffusion layers 30 and cooling channels 40" may be disposed at the rears of the solar cells 20 such that the thermal diffusion layers 30 and the cooling channels 40" are thermally insulated by heat insulators 50, and the installation of thermal diffusion layers, cooling channels, and heat insulators at the rears of the reflectors 81 and 82; 83 and 84 may be omitted.

Consequently, solar energy incident upon the reflectors 81 and 82; 83 and 84 is reflected and guided to the other two opposite edges of the condenser 10, where the solar energy is converted into electricity by the solar cells 20, and solar heat is recovered by the thermal diffusion layers 30 and the cooling channels 40" disposed at the rears of the solar cells 20.

In the embodiment of FIG. 7, the reflectors 81 and 82 are constructed in a symmetrical structure at the upper and lower edges of the condenser 10, respectively, on the drawing, with the result that left parts 81 a and 82a of the upper and lower reflectors 81 and 82 reflect and transmit solar energy to the left solar cell 20 side, and right parts 81 b and 82b of the upper and lower reflectors 81 and 82 reflect and transmit solar energy to the right solar cell 20 side, on the drawing.

In the embodiment of FIG. 8, the reflectors 83 and 84 are disposed at the upper and lower edges of the condenser 10, respectively, such that the reflectors 83 and 84 have sawteeth arranged in opposite directions, on the drawing, with the result that the upper reflector 83 reflects and transmits solar energy to the right solar cell 20 side, and the lower reflector 84 reflects and transmits solar energy to the left solar cell 20 side of the drawing.

In the embodiments of FIGS. 7 and 8, the installation angles of the reflectors 81 and 82; 83 and 84 may not be the same but are instead partially different from each other. Also, the reflectors may be formed in the shape of a polygon or an arc, in addition to the sawteeth, to improve the distribution of energy reflected.

Hereinafter, a photovoltaic-thermal hybrid apparatus according to a further embodiment will be described.

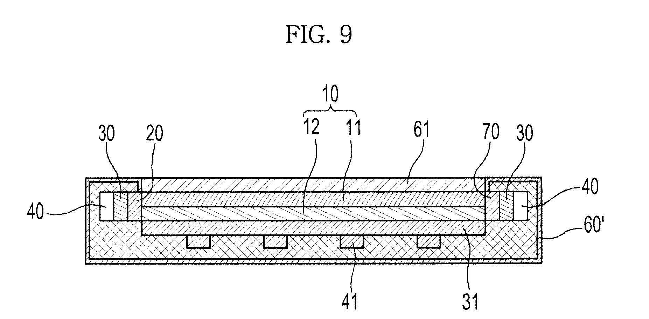

FIG. 9 is a sectional view schematically illustrating a photovoltaic-thermal hybrid apparatus according to a further embodiment of the present invention.

The photovoltaic-thermal hybrid apparatus according to this embodiment is identical to that according to the embodiment of FIG. 1, except that a pair of neighboring solar cells are replaced by reflectors, and thermal diffusion layers and additional cooling channels are disposed at the bottom of a second condenser.

The same elements of this embodiment as the embodiment of FIG. 1 are denoted by the same reference numerals, and a description thereof will not be given.

As shown in FIG. 9, the photovoltaic-thermal hybrid apparatus may include first cooling channels 40 disposed at the rears of the first thermal diffusion layers 30 to cool the solar cells 20 and recover solar heat, a second thermal diffusion layer 31 disposed at the bottom of a second condenser 12 to absorb solar energy passing through the second condenser 12 and second cooling channels 41 disposed at the second thermal diffusion layer 3 to recover solar energy passing through the second condenser 12. Also shown in FIG. 9 is the frame 60' according to the present embodiment.

In the photovoltaic-thermal hybrid apparatus according to this embodiment, the first cooling channels 40 are disposed at the rears of the reflectors 70 to prevent the reflectors 70 from overheating and recover heat, and the second cooling channels 41 are disposed at the bottom of the second condenser 12 to further recover heat, thereby minimizing heat loss and thus improving efficiency.

Hereinafter, modifications of the cooling channel in the photovoltaic-thermal hybrid apparatus according to this embodiment will be described.

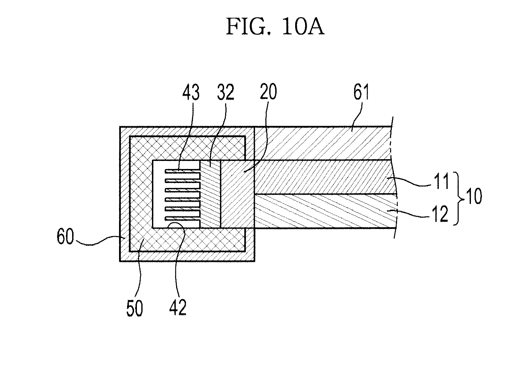

FIGS. 10A to 10E are sectional views illustrating modifications of the cooling channel in the photovoltaic-thermal hybrid apparatus according to the embodiments of the present invention.

In a modification of FIG. 10A, heat exchange fins 43 are disposed in a cooling channel 42 to enlarge heat transfer area.

The heat exchange fins 43 protrude from a thermal diffusion layer 32 toward the cooling channel 32 by a predetermined length, with the result that the heat transfer area is enlarged, and therefore, it is possible to improve heat exchange efficiency even if the amount of heat emitted from the corresponding solar energy 20 is great. The heat exchange fins 43 protrude from the thermal diffusion layer 32; however, the installation position of the heat exchange fins 43 is not limited to the thermal diffusion layer.

To accelerate turbulent flow or disturb the boundary layer of a cooling fluid, the heat exchange fins 43 to enlarge the heat transfer area may be arranged at predetermined intervals, may have holes formed in the middle parts thereof, or be arranged perpendicular or inclined to the flow direction. Also, the heat exchange fins 43 may be arranged in a screw thread shape to create a swirl or vortex.

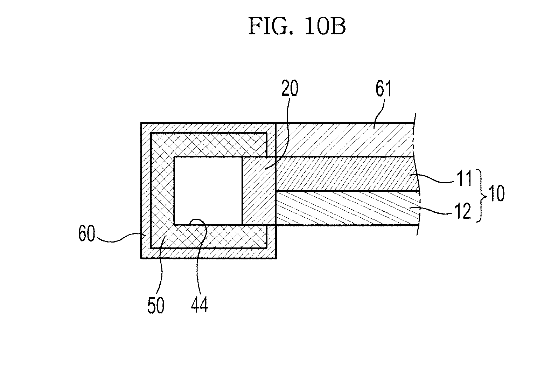

In a modification of FIG. 10B, no thermal diffusion layer is provided, and a cooling channel 44 is directly disposed at the rear of the corresponding solar cell 20.

When the amount of heat emitted from the solar cell 20 per unit area is great, the thermal diffusion layer itself acts as considerable heat resistance. Consequently, it is possible to remove the thermal diffusion layer acting as the heat resistance by directly disposing the cooling channel 44 at the rear of the solar cell 20.

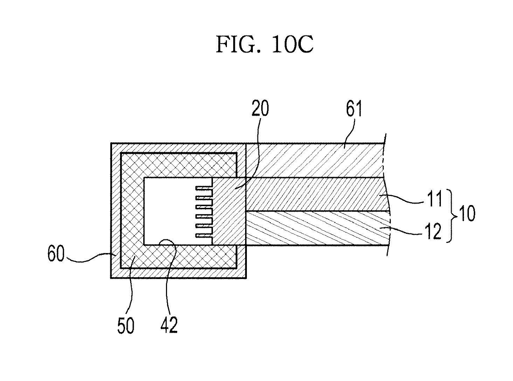

In a modification of FIG. 10C, heat exchange fins 45 having a pattern similar to that of FIG. 10A are disposed at the rear of the corresponding solar cell 20 in the modification of FIG. 10B to enlarge heat transfer area.

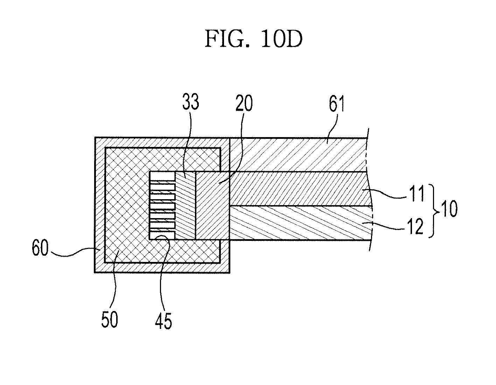

A modification of FIG. 10D is constructed in a structure in which micro cooling channels 45 are formed at a thermal diffusion layer 33 to improve heat exchange efficiency.

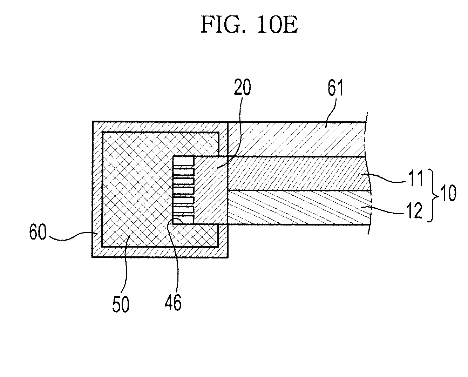

A modification of FIG. 10E is constructed in a structure in which the thermal diffusion layer is omitted from the modification of FIG. 10D, and micro cooling channels 46 are directly formed at the rear of the solar cell 20. In this structure, it is possible to remove heat resistance due to the thermal diffusion layer when the amount of heat emitted from the solar cell 20 per unit area is great.

The photovoltaic-thermal hybrid apparatus according to any one of the previous embodiments may be used in a building integrated photovoltaic (BIPV) power generation system which is integrated with an external ornament, such as a wall or a roof, of a building, or of which the installation thickness must be minimized. Unlike the conventional BIPV system, the photovoltaic-thermal hybrid apparatus according to any one of the previous embodiments is also capable of recovering heat. Consequently, the photovoltaic-thermal hybrid apparatus according to any one of the previous embodiments constitutes a combined heat and power (CHP) generation system that is capable of using heat as well as electricity, which is distinguished from the conventional BIPV system. Also, the photovoltaic-thermal hybrid apparatus according to any one of the previous embodiments may be applicable to any fields requiring photovoltaic power generation in addition to the BIPV system.

As is apparent from the above description, it is possible to manufacture the photovoltaic-thermal hybrid apparatus in a very thin module structure to achieve photovoltaic power generation and heat recovery by using the flat panel type condenser and installing the solar cells and the cooling and heat recovery channels at the narrow edges of the condenser.

Also, it is possible to manufacture the photovoltaic-thermal hybrid apparatus in a very thin module structure by disposing the solar cells at the edges of the condenser, and therefore, it is possible to minimize the restrictions of an installation location and installation condition which a common large-volume concentration type photovoltaic system suffers.

Also, it is possible to minimize the use of the high-priced solar cells and the installation of the cooling channels by installing the reflectors at the edges of the condenser, thereby reducing the manufacturing costs and simplifying the manufacturing process.

Although a few embodiments of the present invention have been shown and described, it would be appreciated by those skilled in the art that changes may be made in these embodiments without departing from the principles and spirit of the invention, the scope of which is defined in the claims and their equivalents.

## Claims

1. A photovoltaic-thermal hybrid apparatus comprising:
at least one condenser to change a direction of some incident solar energy therein in a radial direction and emit some incident solar energy outside;
a solar cell disposed at at least one side of the condenser; and
a frame to surround the condenser, the frame having a first cooling channel to cool the solar cell disposed at at least one side therein.

2. The photovoltaic-thermal hybrid apparatus according to claim 1, further comprising a thermal diffusion layer disposed between the solar cell and the first cooling channel to transmit energy that has not been converted into electricity by the solar cell to the first cooling channel.

3. The photovoltaic-thermal hybrid apparatus according to claim 1 or claim 2, further comprising a heat insulator to fix the solar cell and the first cooling channel and to thermally insulate the solar cell and the first cooling channel from the outside.

4. The photovoltaic-thermal hybrid apparatus according to any of claim 1 to claim 3, wherein the at least one condenser comprises a plurality of stacked condensers, and the condensers transmit the solar energy to the neighboring condensers.

5. The photovoltaic-thermal hybrid apparatus according to any of claim 1 to claim 3, further comprising a reflector disposed at another side of the condenser to reflect the solar energy to the solar cell.

6. The photovoltaic-thermal hybrid apparatus according to claim 5, wherein the solar cell comprises solar cells disposed at some sides of the condenser, and the reflector comprises reflectors disposed at the remaining sides of the condenser.

7. The photovoltaic-thermal hybrid apparatus according to claim 5 or claim 6, wherein the reflector is inclined toward the solar cell.

8. The photovoltaic-thermal hybrid apparatus according to any of claim 5 to claim 7, further comprising a second cooling channel disposed at a rear of the reflector to cool the reflector and recover solar heat.

9. The photovoltaic-thermal hybrid apparatus according to claim 8, further comprising a thermal diffusion layer disposed between the reflector and the second cooling channel to transmit energy from the reflector to the cooling channel.

10. The photovoltaic-thermal hybrid apparatus according to claim 2, further comprising a heat insulator disposed in the frame to surround the thermal diffusion layer and the first cooling channel and prevent discharge of heat.

11. The photovoltaic-thermal hybrid apparatus according to any of claim 1 to claim 10, further comprising a heat exchange fin disposed at a rear of the solar cell to enlarge a heat exchange area.

12. The photovoltaic-thermal hybrid apparatus according to claim 1, wherein the first cooling channel comprises a micro channel configured in a micro structure to form a fluid flow channel.

13. The photovoltaic-thermal hybrid apparatus according to claim 1, wherein the first cooling channel comprises an introduction port through which a fluid is introduced, a plurality of channel parts diverging from the introduction port to surround the solar cell, and a discharge port, joining the channel parts, through which the fluid is discharged.

14. The photovoltaic-thermal hybrid apparatus according to claim 1, further comprising a heat insulator filling the frame.

15. The photovoltaic-thermal hybrid apparatus according to claim 8, further comprising a third cooling channel disposed at a bottom of the condenser recover heat from the condenser.
